# EUROPÄISCHE PATENTANMELDUNG

(11) **EP 1 970 920 A1**
(43) Veröffentlichungstag der Anmeldung: **17.09.2008**
(21) Anmeldenummer: 08004453.0
(22) Anmeldetag: 11.03.2008
(51) Int. Cl.: H01F 6/00

(54) **Horizontale Magnetanordnung mit radialem Zugang**

(30) Priorität: 16.03.2007 DE 102007013349
(71) Anmelder: Bruker BioSpin AG, 8117 Fällanden (CH)
(72) Erfinder: Venturini, Francesca, 8600 Dübendorf (CH); Mock, Patrick, 8610 Uster (CH); Schauwecker, Robert, 8004 Zürich (CH)
(74) Vertreter: Kohler Schmid Möbus

(57) **Zusammenfassung**

Eine Magnetanordnung mit einem supraleitenden Magnetspulensystem (M) zur Erzeugung eines Magnetfeldes in Richtung einer horizontalen z-Achse in einem entlang der z-Achse um z=0 angeordneten Arbeitsvolumen (V) mit mindestens einem radialen Zugang zum Arbeitsvolumen (V) senkrecht zur z-Achse, wobei das Magnetspulensystem mindestens eine koaxial um die z-Achse angeordnete Teilwicklung (A1a,A1b) bei z>0 und mindestens eine koaxial um die z-Achse angeordnete Teilwicklung (B1a,B1b) bei z<0 umfasst, ist dadurch gekennzeichnet, dass sowohl zumindest eine der Teilwicklungen (A1a,A1b) bei z>0 als auch zumindest eine der Teilwicklungen (B1a,B1b) bei z<0 von einem gemeinsamen Formkörper (K1) getragen werden, wobei der Formkörper (K1) mindestens eine Öffnungen (O1) bei z=0 aufweist, welche den radialen Zugang zum Arbeitsvolumen (V) ermöglicht, wobei der Formkörper (K1) die axialen magnetischen Kräfte zwischen den Teilwicklungen aufnimmt und wobei der Formkörper auf einer Stirnseite kraftschlüssig mit einer ersten Seitenplatte (F1) mechanisch verbunden ist. Hierdurch wird eine stabile und kompakte Magnetanordnung mit radialem Zugang realisiert.

## Beschreibung

Die Erfindung betrifft eine Magnetanordnung mit einem supraleitenden Magnetspulensystem zur Erzeugung eines Magnetfeldes in Richtung einer horizontalen z-Achse in einem entlang der z-Achse um z=0 angeordneten Arbeitsvolumen mit mindestens einem radialen Zugang zum Arbeitsvolumen senkrecht zur z-Achse, wobei das Magnetspulensystem mindestens eine koaxial um die z-Achse angeordnete Teilwicklung bei z>0 und mindestens eine koaxial um die z-Achse angeordnete Teilwicklung bei z<0 umfasst.

Eine solche Magnetanordnung ist bspw. aus [6] für NMR-Experimente bekannt.

Horizontale Magnetanordnungen werden insbesondere für MRI- aber auch für EPR-Experimente verwendet. Dabei wird das Magnetfeld im Allgemeinen mittels Solenoidspulen mit horizontaler Achse (z-Achse) erzeugt.

Aus [1] - [6] sind so genannte "Split Coil" Magnetanordnungen bekannt. Diese bestehen aus zwei getrennten Spulen oder Spulensystemen, die spiegelsymmetrisch bezüglich einer Ebene, die senkrecht zur z-Achse ist, angeordnet sind. Hierdurch wird ein radialer Zugang (senkrecht zur z-Achse) zum Arbeitsvolumen ermöglicht, um bspw. Proben oder Messeinrichtungen in das oder aus dem Arbeitsvolumen zu transferieren. Die Spulensysteme sind separat auf zwei oder mehreren Formkörpern gewickelt, welche durch eine mechanische Struktur (oder einen Stützkörper) zusammengehalten werden [3, 4]. Aus [4, 5, 6] sind darüber hinaus Magnetanordnungen bekannt, deren mechanische Struktur beziehungsweise deren Stützkörper die axialen Kräfte zwischen den zwei Spulensystemen aufnimmt.

Problematisch bei den bekannten Magnetanordnungen ist, dass die Formkörper, die Flansche und die mechanische Struktur, welche die Formkörper zusammenhalten, im Spalt zusammen fixiert werden müssen. Dies hat eine Reduzierung des knapp bemessenen Platzes im Spalt zur Folge.

Auch bewirkt das Zusammenbauen der verschiedenen Formkörper eine Produktionsungenauigkeit, was sich wiederum auf die Homogenität des Magnetfeldes der Magnetanordnung auswirkt. Ein weiteres Problem bezüglich der Feldhomogenität entsteht dann, wenn die real wirkenden magnetischen Kräfte von den im Design theoretisch berechneten Werten abweichen und es zu einer Verschiebung der Spulensysteme gegeneinander kommt.

Durch die Entwicklung der einzelnen Spulensystemen, der Montage, sowie der Verbindung dieser Spulensysteme ergibt sich darüber hinaus eine aufwändige Fertigung.

Aufgabe der vorliegenden Erfindung ist es daher, eine Magnetanordnung der eingangs genannten Art vorzuschlagen, bei welcher diese Probleme vermieden werden.

Diese Aufgabe wird erfindungsgemäß dadurch gelöst, dass sowohl zumindest eine der Teilwicklungen bei z>0 als auch zumindest eine der Teilwicklungen bei z<0 von einem gemeinsamen Formkörper getragen werden, wobei der Formkörper mindestens eine Öffnungen bei z=0 aufweist, welche den radialer Zugang zum Arbeitsvolumen ermöglicht, wobei der Formkörper die axialen magnetischen Kräfte zwischen den Teilwicklungen aufnimmt und wobei der Formkörper auf einer Stirnseite kraftschlüssig mit einer ersten Seitenplatte mechanisch verbunden ist.

Die Teilwicklungen sind bei der erfindungsgemäßen Magnetanordnung auf einem gemeinsamen Formkörper aufgebracht, insbesondere aufgewickelt. Durch die Verwendung eines gemeinsamen Formkörpers kann auf eine mechanische Struktur oder einen Stützkörper zur Fixierung der Formkörper verzichtet werden. Dies hat zur Folge, dass kein Platz für Fixierungsmittel benötigt wird. Die Teilwicklungen können daher direkt bis zur Öffnung des Formkörpers gewickelt werden und die Magnetanordung wird dadurch besonders kompakt. Im Gegensatz zum Stand der Technik ist ein Zusammenfügen von Formkörper-Einzelteilen nicht notwendig, so dass auf diese Fertigungsschritte verzichtet werden kann. Der gemeinsame Formkörper erlaubt darüber hinaus einen guten Wärmeübertrag zwischen den einzelnen Telwicklungen. Vorteilhaft ist auch, dass die auf die Teilwicklungen wirkenden Kräfte auf einen einzigen Formkörper übertragen werden, da auf diese Weise eine ungewollte Bewegung verschiedener Formkörper-Teile gegeneinander vermieden wird. Die größere mechanische Präzision bewirkt auch eine bessere Übereinstimmung des tatsächlich erzeugten mit dem berechneten Feld.

Eine bevorzugte Ausführungsform der erfindungsgemäßen Magnetanordnung sieht vor, dass in der Schnittfläche senkrecht zur z-Achse bei z=0 die Fläche des

Materialquerschnitts des Formkörpers mindestens 5% einer Ringfläche mit Flächeninhalt (rₐ²-rᵢ²)π beträgt, wobei rₐ : größter Abstand der Außenkontur des Materialquerschnitts zur z-Achse bei z=0, mit rₐ>0, und rᵢ : kleinster Abstand der Innenkontur des Materialquerschnitts zur z-Achse bei z=0, mit rᵢ>=0. Auf diese Weise wird die notwendige Stabilität des Formkörpers gewährleistet, wobei gleichzeitig eine großzügige Öffnung für den radialen Zugang realisiert werden kann.

Vorzugsweise ist der Formkörper mit einer zweiten Seitenplatte formschlüssig mechanisch verbunden. Die Seitenplatten dienen zur Fixierung des Formkörpers und der darauf angebrachten Teilwicklungen mit dem Gehäuse der Magnetanordnung. Im Gegensatz zu einer formschlüssigen mechanischen Verbindung der zweiten Seitenplatte wäre eine kraftschlüssige Verbindung sowohl der ersten als auch der zweiten Seitenplatte statisch überbestimmt.

Besonders bevorzugt ist eine Ausführungsform der erfindungsgemäßen Magnetanordnung, bei der zumindest in einem der Formkörper zur Durchführung eines Drahtes mindestens ein Kanal vorhanden ist, der eine erste Kammer des Formkörpers, in der eine der Teilwicklungen bei z>0 angeordnet ist, mit einer zweiten Kammer des Formkörpers, in der einer der Teilwicklungen bei z<0 angeordnet ist, verbindet. Auf diese Weise können die Teilwicklungen in einem einzigen Vorgang gewickelt werden. Die Anzahl der Joints und somit der Produktions- und Fertigungsaufwand reduziert sich hierdurch.

Eine besonders bevorzugte Ausführungsform sieht vor, dass das Magnetspulensystem mindestens einen zusätzlichen Formkörper mit mindestens einer radialen Öffnung bei z=0 umfasst, wobei die radialen Öffnungen der Formkörper kollinear zueinander angeordnet sind und den radialen Zugang senkrecht zur z-Achse zum Arbeitsvolumen ermöglichen. Auf diesem zweiten Formkörper können bspw. Kompensationsspulen zur Reduktion des Streufelds der Magnetanordnung oder Shimspulen zur Verbesserung der Homogenität des Gesamtmagnetfeldes angebracht sein.

Bei einer speziellen Ausführungsform dieser erfindungsgemäßen Magnetanordnung sind je zwei Teilwicklungen spiegelsymmetrisch bezüglich der Mittelebene der Formkörper angebracht, wobei die Mittelebene durch z=0 geht und senkrecht zur z-Achse steht. Symmetrisch angeordnete Paare von Teilwicklungen auf verschiedenen Formkörpern erzeugen keine resultierenden magnetischen Kräfte zwischen den Formkörpern.

In einer solchen Ausführungsform ist es besonders vorteilhaft, wenn mindestens eine der Teilwicklungen bei z>0 mit mindestens einer der Teilwicklungen bei z<0 als Schutzabschnitt zusammen in Serie geschaltet ist, wobei der Schutzabschnitt parallel zu einem gemeinsamen Schutzelement geschaltet ist. Die Schutzelemente schützen die supraleitenden Teilspulensysteme in dem jeweiligen Schutzabschnitt im Fall eines Quenchs, so dass ein zu starkes Anwachsen der magnetischen Kräfte auf die supraleitenden Spulen im Quenchfall verhindert wird. Die Serieschaltung von Teilwicklungen bei z>0 mit Teilwicklungen bei z<0 bewirkt, dass die symmetrische, kraftfreie Feldverteilung auch während eines Quenchs erhalten bleibt.

Darüber hinaus ist es vorteilhaft, wenn ein axialer Zugang zum Arbeitsvolumen entlang der z-Achse vorgesehen ist. Ein axialer Zugang kann beispielsweise zum Probentransfer verwendet werden.

Vorzugsweise ist die Magnetanordnung Teil einer Apparatur für Elektron-Paramagnetische Resonanz (EPR) oder Kernspin Resonanz (NMR).

Insgesamt ergibt sich eine kompakte Magnetanordnung, die mittels vereinfachter Fertigungsverfahren hergestellt werden kann und verbesserte Stabilitäts- und Homogenitätseigenschaften aufweist.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

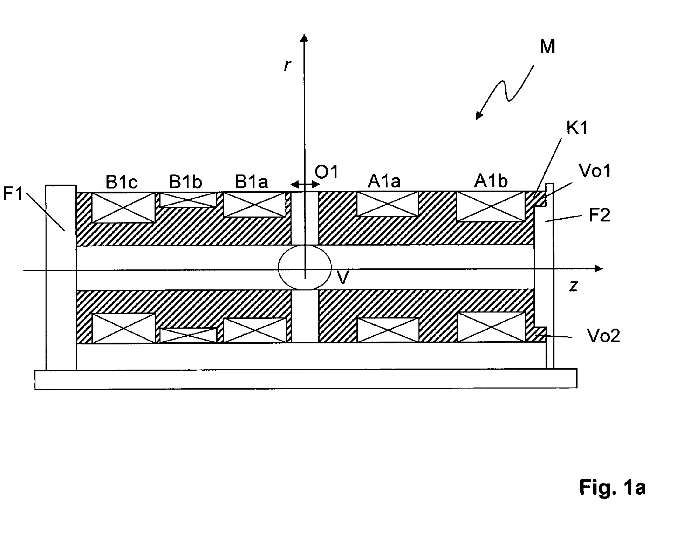

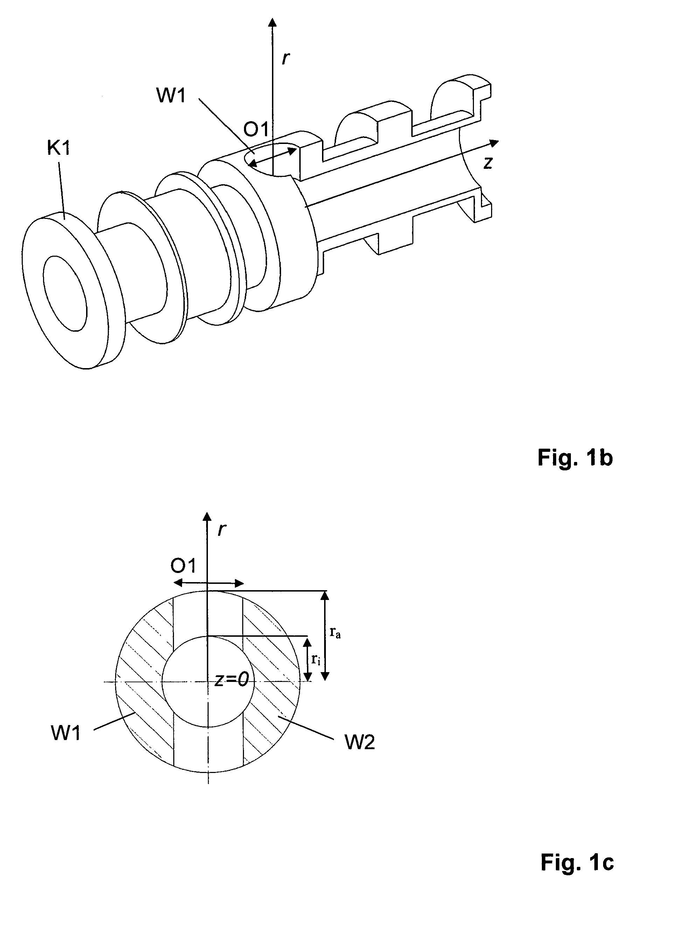

- Figur 1 a: eine Schnittdarstellung einer erfindungsgemäßen Magnetanordnung entlang der z-Achse;
- Figur 1 b: eine dreidimensionale Ausbruchdarstellung eines erfindungsgemäßen Formkörpers;
- Figur 1 c: eine Schnittdarstellung des Formkörper aus Figur 1 b senkrecht zur z-Achse;
- Figur 2: eine Schnittdarstellung einer vorteilhaften Ausführungsform der erfindungsgemäßen Magnetanordnung entlang der z-Achse mit mehreren Formkörpern; und
- Figur 3: ein Verdrahtungsschema einer erfindungsgemäßen Magnetanordnung.

**Figur 1a** zeigt eine Schnittdarstellung der erfindungsgemäßen Magnetanordnung **M** zur Erzeugung eines Magnetfeldes in Richtung einer horizontalen z-Achse. Auf einem um die z-Achse angeordneten rotationssymmetrischen Formkörper **K1** sind Teilwicklungen **A1a, A1b, B1c, B1b, B1c** aufgewickelt. Der Formkörper K1 weist bei z=0 senkrecht zur z-Achse eine Öffnung **O1** auf. Durch diese Öffnung O1 können Proben in ein bei z=0 befindlichen Arbeitsvolumen **V** transferiert werden. Außerdem kann die Öffnung O1 als Durchführung für Messeinrichtungen oder zur Bestrahlung einer im Arbeitsvolumen V angeordneten Probe dienen.

Die Teilwicklungen A1a, A1b, B1a, B1b, B1c sind entlang der z-Achse verteilt angeordnet, so dass sich ein Teil der Teilwicklungen A1 a, A1 b in einem axialen Bereich bei z>0, die anderen Teilwicklungen B1a, B1b, B1c in einem axialen Bereich bei z<0 befinden. Der Formkörper K1 dient zum einen als Tragekörper für die Teilwicklungen A1a, A1b, B1a, B1b, B1c, zum anderen nimmt der Formkörper K1 auch die zwischen den Teilwicklungen A1a, A1b, B1a, B1b, B1c herrschenden axialen magnetischen Kräfte auf.

An einem axialen Ende (Stirnseite) des Formkörpers K1 ist der Formkörper K1 kraftschlüssig mit einer ersten Seitenplatte **F1** verbunden. Darüber hinaus ist eine zweite Seitenplatte **F2,** die der ersten Seitenplatte F1 gegenüber angeordnet ist, mit dem Formkörper K1 durch Formschluss verbunden. Hierzu sind auf der der ersten Seitenplatte F1 zugewandten Seite der zweiten Seitenplatte F2 Ausnehmungen, insbesondere Einfräsungen, vorgesehen, in die Vorsprünge **Vo1, Vo2** des Formkörpers K1 eingreifen. Die Seitenplatten F1, F2 stellen eine Verbindung zu einem Gehäuse her oder sind, wie im vorliegenden Fall selbst Teil des Gehäuses.

**Figur 1b** zeigt den Formkörper K1 aus Figur 1 a in einer räumlichen Darstellung. Die perspektivische Darstellung zeigt deutlich, dass der Formkörper K1 einstückig ist und eine Bohrung als Öffnung O1 mit seitlichen Wandungen **W1, W2** aufweist. Der Formkörper K1 weist mehrere Kammern auf, die zur Aufnahme der Teilwicklungen A1a, A1b, B1a, B1b, B1c bestimmt sind, wobei die einzelnen Kammern verschiedene Abstände von der z-Achse aufweisen können. Die seitlichen Wandungen W1, W2 des Formkörpers K1 im Bereich der Öffnung 01 übernehmen die Funktion der aus dem Stand der Technik bekannten Stützkörper. Im Gegensatz zum Stand der Technik ist bei der erfindungsgemäßen Magnetanordnung jedoch keine Fixierung zwischen Formkörper und Stützkörper notwendig, da die als Stützkörper dienenden Wandungen W1, W2 Teil des Formkörpers K1 selbst sind. Hierdurch ist es möglich beispielsweise die Teilwicklung B1a sehr nahe an der Öffnung 01 zu platzieren, so dass die Ausdehnung der Magnetanordnung M entlang der z-Achse gegenüber dem Stand der Technik reduziert werden kann.

In **Figur 1c** ist der in Figur 1b gezeigte Formkörper K1 in einer Schnittdarstellung senkrecht zur z-Achse bei z=0 gezeigt. Der Formkörper K1 hat bei z=0 einen Querschnitt in Form zweier Kreisringsegmente eines Kreisrings mit einem äußeren Radius **rₐ** und einem inneren Radius **rᵢ** Die durchgehende Öffnung 01 erstreckt sich entlang einer radialen Richtung r senkrecht zur z-Achse und wird durch die seitlichen Wandungen W1, W2 begrenzt, welche eine Verbindung der Teile des Formkörpers K1 bei z<0 und der Teile des Formkörper K1 bei z<0 darstellt. Entlang der z-Achse ist ein axialer Zugang mit Radius rᵢ vorgesehen.

Um die für die Aufnahme der auf den Formkörper K1 wirkenden magnetischen Kräfte notwendige Stabilität zu gewährleisten, ist vorgesehen, dass die Fläche des in Figur 1c gezeigten Querschnitts der Wandungen W1, W2 bei z=0 mindestens 5% von der Fläche des Querschnitts bei z=0 beträgt, die man erhalten würde, wenn man den Formkörper K1 um die z-Achse rotieren würde (Ringfläche mit innerem Radius rᵢ und äußerem Radius rₐ).

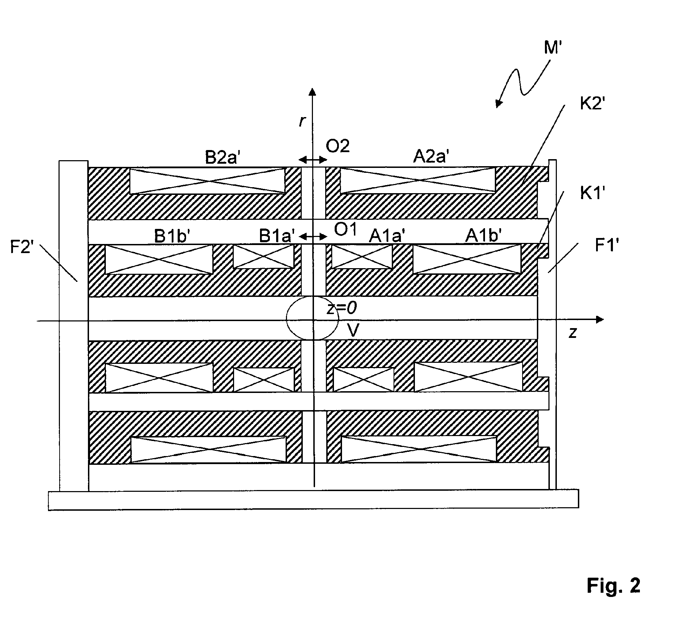

**Figur 2** zeigt eine Schnittdarstellung einer besonders vorteilhaften Ausführungsform der erfindungsgemäßen Magnetanordnung M' mit mehreren Formkörpern **K1', K2'**. Auf dem ersten Formkörper K1' sind vier Teilwicklungen **A1a'**, **A1b', B1a'**, **B1b'** angeordnet. Der zweite Formkörper K2' ist radial außerhalb des ersten Formkörpers K1' und koaxial zu diesem um die z-Achse angeordnet. Auf den zweiten Formkörper K2' sind weitere Teilwicklungen **A2a'**, **B2a'** angebracht. Der zweite Formkörper K2' weist bei z=0 eine Öffnung **O2** auf, die koaxial zur Öffnung 01 des ersten Formkörper K1' ist, so dass ein Zugang zum Arbeitsvolumen V durch beide Formkörper K1', K2' hindurch realisiert wird. Die beiden Formkörper K1', K2' sind durch Seitenplatten **F1', F2'** miteinander verbunden.

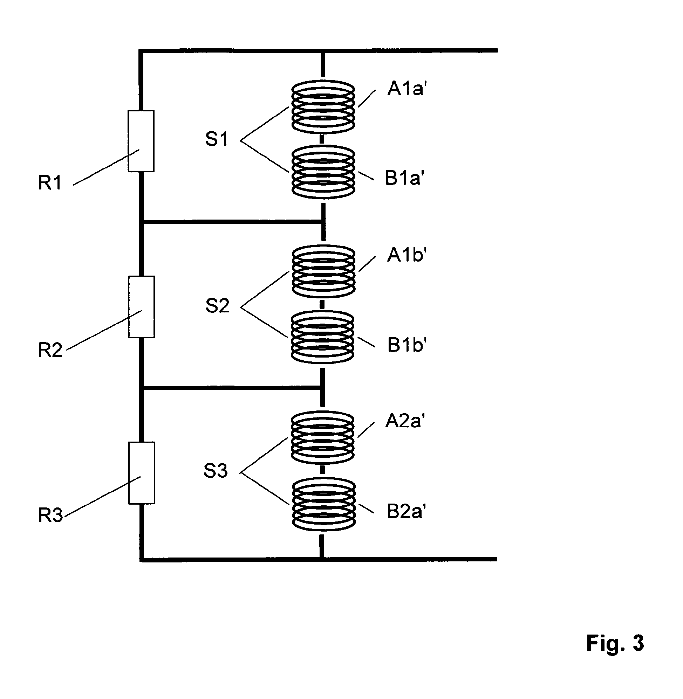

In **Figur 3** ist ein Verdrahtungsschema einer vorteilhaften Ausführungsform der erfindungsgemäßen Magnetanordnung M' mit supraleitenden Spulen gezeigt. Die Teilwicklungen A1a', B1a' und A1b', B1b' sowie A2a', B2a' der Magnetanordnung M' sind je paarweise in Serie geschaltet und bilden drei Schutzabschnitte **S1, S2, S3,** von denen somit jeder jeweils eine Teilwicklung bei z>0 und eine Teilwicklung bei z<0 umfasst. Jeder Schutzabschnitt S1, S2, S3 ist parallel zu je einem Schutzelement **R1, R2, R3** geschaltet. Die Schutzelemente R1, R2, R3 schützen die Teilwicklungen A1a', A1b', B1a', B1b', A2a', B2a' gegen Überhitzung und hohe elektrische Spannungen im Falle eines Zusammenbruchs der Supraleitung (Quench).

### Bezugszeichenliste

- A1 a, A1 b: Teilwicklung bei z>0 auf Formkörper K1
- A1 a', A1 b': Teilwicklung bei z>0 auf Formkörper K1'
- A2a': Teilwicklung bei z>0 auf Formkörper K2'
- B1 a', B1 b': Teilwicklung bei z<0 auf Formkörper K1'
- B1a, B1b, B1c: Teilwicklung bei z<0 auf Formkörper K1
- B2a': Teilwicklung bei z<0 auf Formkörper K2'
- F1, F2, F1', F2': Seitenplatte
- K1, K1', K2': Formkörper
- M, M': Magnetspulensystem
- 01,02: Öffnung
- R1, R2, R3: Schutzelement
- rₐ: Außenradius des Formkörpers K1 bei z=0
- rᵢ: Innenradius des Formkörpers K1 bei z=0
- S1, S2, S3: Schutzabschnitt
- V: Arbeitsvolumen
- Vo1, Vo2: Vorsprung
- W1, W2: Seitliche Wandungen

### Referenzliste

[1] US2006125478
[2] US2005253586
[3] Oxford UHV Nanostat (Brochure auf Webseite: http://www.oxford-instruments.com/wps/wcm/resources/file/eb73224aa540f1a/UHVNanostat.pdf)
[4] US2002145426
[5] E.T. Laskaris et al., IEEE Transactions on Applied Superconductivity, Vol. 5 , No. 2, Juni 1995, Seiten 163 -168.
[6] US2005134414
[7] JP11312606

## Patentansprüche

1. Magnetanordnung mit einem supraleitenden Magnetspulensystem (M) zur Erzeugung eines Magnetfeldes in Richtung einer horizontalen z-Achse in einem entlang der z-Achse um z=0 angeordneten Arbeitsvolumen (V) mit mindestens einem radialen Zugang zum Arbeitsvolumen (V) senkrecht zur z-Achse, wobei das Magnetspulensystem mindestens eine koaxial um die z-Achse angeordnete Teilwicklung (A1a, A1b) bei z>0 und mindestens eine koaxial um die z-Achse angeordnete Teilwicklung (B1a, B1b) bei z<0 umfasst,
**dadurch gekennzeichnet, dass**
sowohl zumindest eine der Teilwicklungen (A1a, A1 b) bei z>0 als auch zumindest eine der Teilwicklungen (B1a, B1 b) bei z<0 von einem gemeinsamen Formkörper (K1) getragen werden,
wobei der Formkörper (K1) mindestens eine Öffnungen (O1) bei z=0 aufweist, welche den radialer Zugang zum Arbeitsvolumen (V) ermöglicht,
wobei der Formkörper (K1) die axialen magnetischen Kräfte zwischen den Teilwicklungen aufnimmt und
wobei der Formkörper auf einer Stirnseite kraftschlüssig mit einer ersten Seitenplatte (F1) mechanisch verbunden ist.

2. Magnetanordnung nach Anspruch 1, **dadurch gekennzeichnet, dass** in der Schnittfläche senkrecht zur z-Achse bei z=0 die Fläche des Materialquerschnitts des Formkörpers (K1) mindestens 5% einer Ringfläche mit Flächeninhalt (rₐ²- rᵢ²)π beträgt, wobei
rₐ : größter Abstand der Außenkontur des Materialquerschnitts zur z-Achse bei z=0, mit rₐ>0, und
rᵢ: kleinster Abstand der Innenkontur des Materialquerschnitts zur z-Achse bei z=0, mit rᵢ>=0.

3. Magnetanordnung nach einem der vorhergehenden Ansprüche, **dadurch gekennzeichnet, dass** der Formkörper (K1) mit einer zweiten Seitenplatte (F2) formschlüssig mechanisch verbunden ist.

4. Magnetanordnung nach einem der vorhergehenden Ansprüche, **dadurch gekennzeichnet, dass** im Formkörper (K1) zur Durchführung eines Drahtes mindestens ein Kanal vorhanden ist, der eine erste Kammer des Formkörpers, in der eine der Teilwicklungen (A1a, A1b,) bei z>0 angeordnet ist, mit einer zweiten Kammer des Formkörpers, in der einer der Teilwicklungen (B1a, B1b, B1c) bei z<0 angeordnet ist, verbindet.

5. Magnetanordnung nach einem der vorhergehenden Ansprüche, **dadurch gekennzeichnet, dass** das Magnetspulensystem mindestens einen zusätzlichen Formkörper (K2') mit mindestens einer radialen Öffnung (O2) bei z=0 umfasst, wobei die radialen Öffnungen (01, 02) der Formkörper (K1, K2') kollinear zueinander angeordnet sind und den radialen Zugang senkrecht zur z-Achse zum Arbeitsvolumen (V) ermöglichen.

6. Magnetanordnung nach Anspruch 5, **dadurch gekennzeichnet, dass** je zwei Teilwicklungen (A1a', B1a'; A1b', B1b'; A2a', B2a') spiegelsymmetrisch bezüglich der Mittelebene der Formkörper (K1', K2') angebracht sind, wobei die Mittelebene durch z=0 geht und senkrecht zur z-Achse steht.

7. Magnetanordnung nach Anspruch 6, **dadurch gekennzeichnet, dass** mindestens eine der Teilwicklungen (A1a', A1b', A2a') bei z>0 mit mindestens einer der Teilwicklungen (B1a', B1b', B2a') bei z<0 als Schutzabschnitt (S1, S2, S3) zusammen in Serie geschaltet ist, wobei der Schutzabschnitt (S1, S2, S3) parallel zu einem gemeinsamen Schutzelement (R1, R2, R3) geschaltet ist.

8. Magnetanordnung nach einem der vorhergehenden Ansprüche, **dadurch gekennzeichnet, dass** ein axialer Zugang zum Arbeitsvolumen (V) entlang der z-Achse vorgesehen ist.

9. Magnetanordnung nach einem der vorhergehenden Ansprüche, **dadurch gekennzeichnet, dass** die Magnetanordnung Teil einer Apparatur für Elektron-Paramagnetische Resonanz (EPR) oder Kernspin Resonanz (NMR) ist.
